# EUROPEAN PATENT APPLICATION

(11) **EP 2 728 583 A1**
(43) Date of publication of application: **07.05.2014**
(21) Application number: 13191422.8
(22) Date of filing: 04.11.2013
(51) Int. Cl.: G11C 19/28

(54) **Bi-directional shift register, gate driving circuit and display apparatus**

(30) Priority: 02.11.2012 CN 201210434189
(71) Applicant: BOE Technology Group Co., Ltd., Beijing 100016 (CN); Hefei BOE Optoelectronics Technology Co., Ltd., Hefei Anhui 230012 (CN)
(72) Inventor: Ma, Rui, 100176 Beijing (CN); Shao, Xianjie, 100176 Beijing (CN); Wang, Guolei, 100176 Beijing (CN); Hu, Ming, 100176 Beijing (CN)
(74) Representative: Klunker . Schmitt-Nilson . Hirsch

(57) **Abstract**

The present disclosure relates to a field of liquid crystal display, and discloses a shift register, a gate driving circuit and a display apparatus, wherein the shift register comprises a precharging module, a pulling-up module, a pulling-down driving module, a pulling-down module and a resetting module, each shift register may perform a bi-directional scanning, that is, it may scan not only forward but also backward, so that a cost for producing the liquid crystal display including the shift registers is reduced, and a manufacturing efficiency is increased.

## Description

### TECHNICAL FIELD

The present disclosure relates to a technical field of liquid crystal display, and particularly, to a shift register, a gate driving circuit and a display apparatus.

### BACKGROUND

Since the technology for liquid crystal display continues to mature, and the price of TFT-LCDs (Thin Film Transistor-Liquid Crystal Display) continues to decline, the use of the LCD screen as a display in variety of electronic devices or decorative electric display in life has gradually become a development direction of consumption in the liquid crystal displays. Liquid crystal display screens in the prior art have been widely used in a variety of appliances, such as LCD TVs, mobile phones and so on.

In the liquid crystal display, voltages are applied to liquid crystal molecules having a specific molecular structure to change arrangement of the liquid crystal molecules. Changes in the structure of liquid crystal molecules causes changes in optical properties, such as a birefringence, an optical rotary power, a color separation, a light scattering. In the liquid crystal display, such changes in the optical properties are utilized to display ilnages. The LCD generally includes a liquid crystal display panel, a scan driving circuit (Gate Driver) and a data driving circuit (Source Driver). Among them, the liquid crystal display panel includes a CF (Color Filter) substrate and a TFT array substrate boxed together, and a liquid crystal layer sandwiched therebetween, the gate driving circuit and the data driving circuit are connected with TFT switching elements on the array substrate, respectively.

The liquid crystal display consists of a plurality of pixels arranged in a matrix manner, in particular of a pixel matrix in horizontal and vertical directions. A driving part of the liquid crystal display mostly includes a data driving circuit and a gate driving circuit, wherein the data driving circuit latches input display data sequentially according to a timing of a clock signal, inputs it to data lines of the liquid crystal display panel after converting the same into analog signals, the gate driving circuit converts the input clock signals as ON/OFF voltage (that is, a gate input signal) through a conversion in shift registers and applies them on gate lines of the liquid crystal display panel sequentially. The LCD outputs the gate input signal and scans pixels progressively when it displays. An operation principle of the conventional liquid crystal display is to drive the pixels on the panel to display images with an external driving chip. But in order to reduce the number of components and lower manufacturing costs, in recent years the driving circuit structure has developed to be manufactured directly on the display panel, for example, the gate driving circuit is disposed in the liquid crystal display panel in a manner of COF (Chip On Film) encapsulation or COG (Chip On Glass) encapsulation, or also can embedded in the liquid crystal display panel by constituting an integrated circuit unit with a-si TFTs.

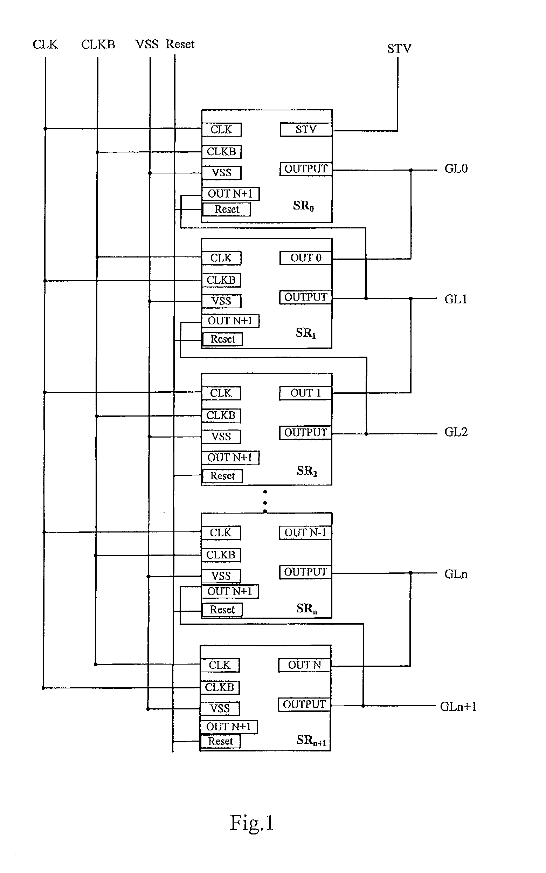

Fig.1 is a schematic structure diagram illustrating a gate driving circuit of a liquid crystal display in the prior art. The gate driving circuit comprises a plurality of gate lines GL0-GLn+1 and a plurality of shift register stages SR0-SRn+1 which are connected in cascade, each shift register stage includes a signal input terminal, a signal output terminal, a voltage input terminal, a clock signal input terminal and a reset terminal, and the signal output terminal of each shift register stage couples with a corresponding one of the gate lines GL0-GLn+1. The gate driving circuit may output a gate driving signal sequentially to the corresponding one of the gate lines GL0-GLn+1 through the shift register stages SR0-SRn+1, respectively, in accordance with clock signals CLK, CLKB and a start signal STV.

Referring to Fig.1, the gate driving circuit comprises a plurality of shift register stages, and signals are output sequentially from the respective shift register stages and applied to the gate lines respectively, that is, the shift register stages are used to drive the gate lines of the liquid crystal display. Each shift register stage includes one signal input terminal, one signal output terminal, one voltage source terminal and two clock signal terminals. Each shift register stage is connected with a clock signal source so as to apply clock signals generated by the clock signal source to each of the shift register stages. The start voltage STV is input to the first shift register stage, and after the first shift register stage, an output signal from a previous shift register stage is input to a current shift register stage, as the start voltage for the current shift register stage. The respective shift register stages in the gate driving circuit are used to generate gate line scanning signals for scanning the respective gate lines.

Most of the gate driving circuits in the prior art only can realize an unidirectional scan, therefore a cost for producing the liquid crystal display including the shift registers is high, a process for producing the liquid crystal display is complex, thereby the manufacturing efficiency being low.

### SUMMARY

Embodiments of the present disclosure provide a shift register, a gate driving circuit, and a liquid crystal display, in order to settle problems occurred in the prior art that a cost for producing the liquid crystal display including the shift registers is high, a process for producing the liquid crystal display is complex and the manufacturing efficiency is low.

According to an aspect of the embodiments of the present disclosure, there is provided a shift register comprising a precharging module, a pulling-up module, a pulling-down driving module, a pulling-down module and a resetting module; wherein the precharging module is connected with a first voltage source and a signal input terminal and used for precharging a pulling-up node under the control of a signal of the signal input terminal, the pulling-up node is a connection point between the pulling-up module and the precharging module;

the pulling-up module is connected with a clock signal source and a signal output terminal, and used for connecting the clock signal source to the signal output terminal under the control of a voltage at the pulling-up node;

the pulling-down driving module is connected with the pulling-up node, a third voltage source and a second voltage source, and used for connecting a pulling-down node to the third voltage source under the control of the voltage at the pulling-up node, the pulling-down node is a connection point between the pulling-down driving module and the pulling-down module;

the pulling-down module is connected with the pulling-up node, the pulling-down node, the third voltage source and the signal output terminal, and used for connecting the pulling-up node to the third voltage source and connecting the signal output terminal to the third voltage source under the control of a voltage at the pulling-down node;

the resetting module is connected with a fourth voltage source, a reset terminal and the pulling-up node, and used for connecting the pulling-up node to the fourth voltage source under the control of a signal at the reset terminal.

In an example, the precharging module comprises a first transistor, wherein a gate of the first transistor is connected with the signal input terminal, a source of the first transistor is connected with the first voltage source, and a drain of the first transistor is connected with the pulling-up node.

In an example, the pulling-up module comprises: a third transistor, wherein a gate of the third transistor is connected with the pulling-up node, a source of the third transistor is connected with the clock signal source, and a drain of the third transistor is connected with the signal output terminal; and a capacitor connected between the pulling-up node and the signal output terminal.

In an example, the pulling-down driving module comprises: a fifth transistor, wherein a gate of the fifth transistor is connected with a source of the fifth transistor, the source of the fifth transistor is connected with the second voltage source at the same time, and a drain of the fifth transistor is connected with the pulling-down node; and a sixth transistor, wherein a gate of the sixth transistor is connected with the pulling-up node, a drain of the sixth transistor is connected with the third voltage source, and a source of the sixth transistor is connected with the pulling-down node.

In an example, the pulling-down module comprises: a second transistor, wherein a source of the second transistor is connected with the pulling-up node, a drain of the second transistor is connected with the third voltage source, and a gate of the second transistor is connected with the pulling-down node; and a seventh transistor, wherein a gate of the seventh transistor is connected with the pulling-down node, a drain of the seventh transistor is connected with the third voltage source, and a source of the seventh transistor is connected with the signal output terminal.

In an example, the resetting module comprises a fourth transistor, wherein a gate of the fourth transistor is connected with the reset terminal, a drain of the fourth transistor is connected with the fourth voltage source, and a source of the fourth transistor is connected with the pulling-up node.

Preferably, the transistors are N-type field effect transistors, and a size ratio between the fifth transistor and the sixth transistor is a preset value.

According to another aspect of the embodiments of the present disclosure, there is provided a gate driving circuit comprising: n shift registers as described above, wherein the third voltage source inputs a low level signal while the second voltage source inputs a high level signal in each of the shift registers, wherein, when a forward scanning is performed, the first voltage source outputs a high level signal while the fourth voltage source outputs a low level signal in each of the shift registers; when a backward scanning is performed, the first voltage source outputs a low level signal while the fourth voltage source outputs a high level signal in each of the shift registers; the signal output terminal of each of the shift registers is connected to a corresponding gate line, respectively; the signal input terminal of a first shift register of the shift registers is connected to a start signal input terminal; the signal input terminal of a m^{th} shift register of the shift registers is connected to the signal output terminal of a (m-1)^{th} shift register of the shift registers, the signal reset terminal of the m^{th} shift register is connected to the signal output terminal of a (m+1)^{th} shift register of the shift registers, wherein 1<m<n-1.

According to a still another aspect of the embodiments of the present disclosure, there is provided a liquid crystal display comprising the gate driving circuit described above.

The embodiments of the present disclosure provide a shift register, a corresponding gate driving circuit and a corresponding liquid crystal display, wherein the shift register comprises a precharging module, a pulling-up module, a pulling-down driving module, a pulling-down module and a resetting module, each shift register may perform a bi-directional scanning, that is, it may scan not only forward but also backward, which may reduce a cost for producing the liquid crystal display including the shift registers, and at the same time may reduce a process complexity and increase a manufacturing efficiency.

### BRIEF DESCRIPTION OF THE DRAWINGS

Fig.1 is a schematic diagram illustrating a structure of a gate driving circuit in a liquid crystal display in the prior art;

Fig.2 is a schematic diagram illustrating a structure of a shift register according to embodiments of the present disclosure;

Fig.3 is a schematic diagram illustrating a detailed structure of the shift register according to the embodiments of the present disclosure;

Fig.4 is an operation timing sequence diagram when the shift register scans forward according to the embodiments of the present disclosure;

Fig.5 is an operation timing sequence diagram when the shift register scans backward according to the embodiments of the present disclosure;

Fig.6 is a schematic diagram illustrating a structure of a gate driving circuit according to the embodiments of the present disclosure.

### DETAILED DESCRIPTION

Implementations for a shift register unit, a gate driving circuit and a liquid crystal display according to embodiments of the present disclosure will be described below in connection with drawings.

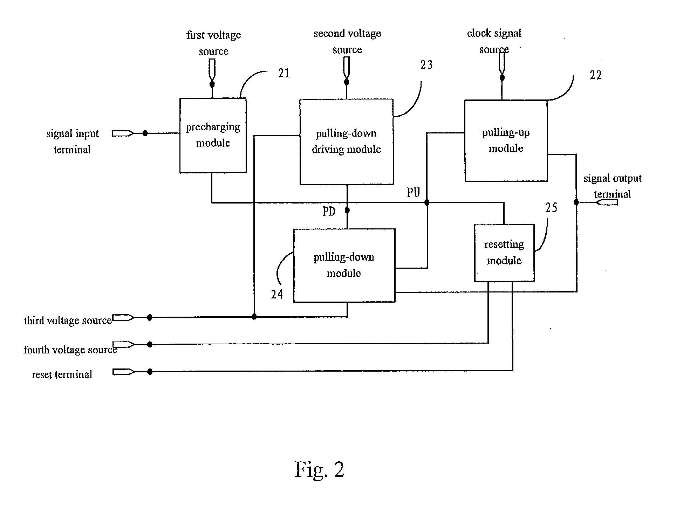

As illustrated in Fig.2, which shows a shift register according to the embodiments of the present disclosure, the shift register comprises a precharging module 21, a pulling-up module 22, a pulling-down driving module 23, a puling-down modue 24 and a resetting module 25.

The precharging module 21 is connected with a first voltage source and a signal input terminal and used for precharging a pulling-up node PU under the control of a signal at the signal input terminal, the pulling-up node PU is a connection point between the puling-up module 22 and the precharging module 21.

The pulling-up module 22 is connected with a clock signal source and a signal output terminal, and used for connecting the clock signal source to the signal output terminal under the control of a voltage at the pulling-up node.

The pulling-down driving module 23 is connected with the pulling-up node PU, a third voltage source and a second voltage source, and used for connecting a pulling-down node PD to the third voltage source under the control of the voltage at the pulling-up node, the pulling-down node PD is a connection point between the pulling-down driving module 23 and the pulling-down module 24.

The pulling-down module 24 is connected with the pulling-up node PU, the pulling-down node PD, the third voltage source and the signal output terminal, and used for connecting the pulling-up node PU to the third voltage source and connecting the signal output terminal to the third voltage source under the control of a voltage at the pulling-down node.

The resetting module 25 is connected with a fourth voltage source, a reset terminal and the pulling-up node PU, and used for connecting the pulling-up node PU to the fourth voltage source under the control of a signal at the reset terminal.

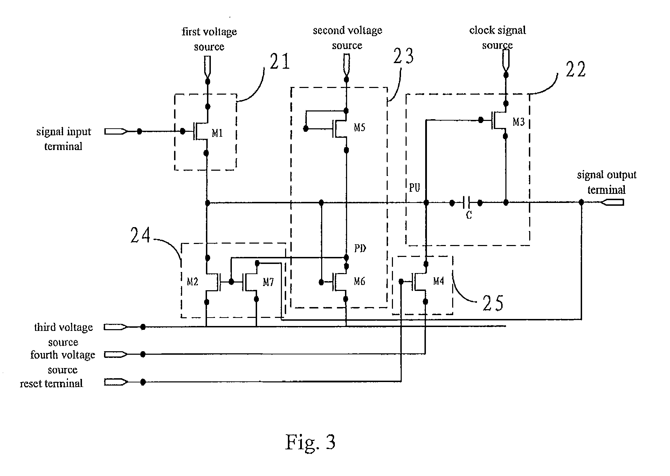

The precharging module 21 may comprise a first transistor M1, wherein a gate of the first transistor M1 is connected with the signal input terminal, a source of the first transistor M1 is connected with the first voltage source, and a drain of the first transistor M1 is connected with the pulling-up node PU, as illustrated in Fig.3.

The pulling-up module 22 may comprise: a third transistor M3, wherein a gate of the third transistor M3 is connected with the pulling-up node PU, a source of the third transistor M3 is connected with the clock signal source, and a drain of the third transistor M3 is connected with the signal output terminal; and a capacitor C connected between the pulling-up node PU and the signal output terminal.

The pulling-down driving module 23 may comprise: a fifth transistor M5, wherein a gate of the fifth transistor M5 is connected with a source of the fifth transistor M5, the source of the fifth transistor M5 is connected with the second voltage source at the same time, and a drain of the fifth transistor M5 is connected with the pulling-down node PD; and a sixth transistor M6, wherein a gate of the sixth transistor M6 is connected with the pulling-up node PU, a drain of the sixth transistor M6 is connected with the third voltage source, and a source of the sixth transistor M6 is connected with the pulling-down node PD.

The pulling-down module 24 may comprise: a second transistor M2, wherein a source of the second transistor M2 is connected with the pulling-up node PU, a drain of the second transistor M2 is connected with the third voltage source, and a gate of the second transistor M2 is connected with the pulling-down node PD; and a seventh transistor M7, wherein a gate of the seventh transistor M7 is connected with the pulling-down node PD, a drain of the seventh transistor M7 is connected with the third voltage source, and a source of the seventh transistor M7 is connected with the signal output terminal.

The resetting module 25 may comprise a fourth transistor M4, wherein a gate of the fourth transistor M4 is connected with the reset terminal, a drain of the fourth transistor M4 is connected with the fourth voltage source, and a source of the fourth transistor M4 is connected with the pulling-up node PU.

In the embodiments of the present disclosure, connection manners for the drain and source in each of the transistors may be exchanged, therefore the source of a transistor mentioned in the embodiments of the present disclosure may be the drain of the transistor, and the drain of the transistor may be the source of the transistor.

In the embodiments of the present disclosure, all of the first transistor M1, the second transistor M2, the third transistor M3, the fourth transistor M4, the fifth transistor M5, the sixth transistor M6 and the seventh transistor M7 may be N-type field effect transistors, that is to say, any one of the first transistor M1, the second transistor M2, the third transistor M3, the fourth transistor M4, the fifth transistor M5, the sixth transistor M6 and the seventh transistor M7 may be turned on only when a difference between a gate voltage and a source voltage of the transistor or a difference between a gate voltage and a drain voltage of the transistor reaches a certain preset threshold.

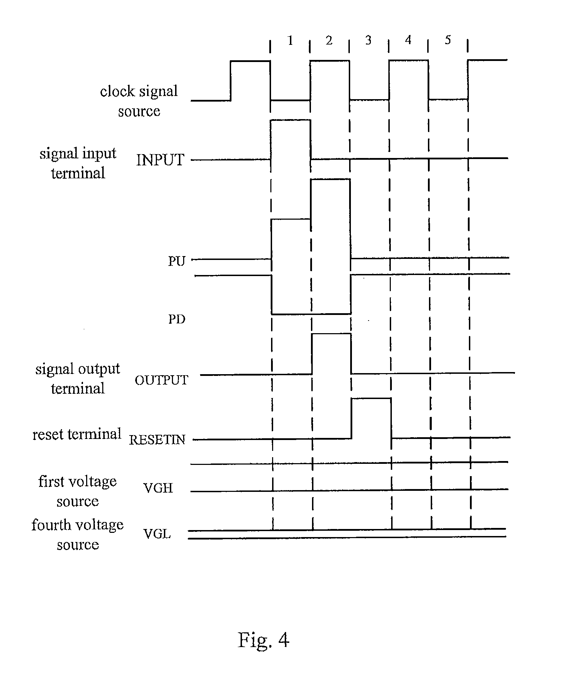

Fig.4 is an operation timing sequence diagram when the shift register scans forward according to the embodiments of the present disclosure. The timing sequqnce for forward scanning of the shift register illustrated in Fig.4 may be divided into five phases, and the first voltage source outputs a high level signal VGH while the fourth voltage source outputs a low level signal VGL during a process of the forward scanning.

In a first phase, the signal input terminal INPUT of the shift register G_n inputs a high level signal, since the input signal at the signal input terminal INPUT of the shift register G_n is an output signal from the signal output terminal OUTPUT of the shift register G_n-1 which at a previous stage of the shift register G_n, it means that the high level signal at the signal output terminal OUTPUT of the shift register G_n-1 at the previous stage is input to the signal input terminal INPUT of the shift register G_n. Then, the first transistor M1 is turned on, the first voltage source charges the capacitor C through the first transistor M1, so a voltage at the PU node is pulled up to the high level, and in turn the sixth transistor M6 and the third transistor M3 are driven by the high level at the PU node to be turned on; by designing the sizes of the fifth transistor M5 and the sixth transistor M6, in particular by making a size ratio between the fifth transistor M5 and the sixth transistor M6 consist with a preset value, a voltage at the pulling-down node PD node is at a low level, therefore the second transistor M2 and the seventh transistor M7 are turned off; the clock signal input terminal CLK inputs a low level signal, the third transistor M3 is turned on, thus the low level signal input from the clock signal input terminal CLK is transferred to the signal output terminal OUTPUT via the third transistor M3.

In a second phase, the signal input terminal INPUT of the shift register G_n inputs a low level signal, the first transistor M1 is turned off, but the voltage at the PU node is still at the high level because the capacitor C has stored the high level signal input from the first voltage source during the first phase, and at this time, the clock signal input terminal CLK inputs a high level signal, so the voltage at the PU node raises because of a bootstrapping effect of the capacitor C, that is to say, the voltage at one terminal of the capacitor C which is connected with the PU node raises continuously on a basis of the voltage obtained during the first phase, and the third transistor M3 remains a turning-on state, so that the high level signal input from the clock signal input terminal CLK is transferred to the signal output terminal OUTPUT via the third transistor M3. The pulling-down node PD goes on to remain the low level as in the first phase, therefore the second transistor M2 and the seventh transistor M7 go on to remain a turning-off state, which may prevent the high level signal output from the signal output terminal OUTPUT from being pulled down to the low level VGL.

In a third phase, the reset terminal RESETIN of the shift register G_n inputs a high level signal, the clock signal input terminal CLK inputs a low level signal, wherein the high level signal input from the reset terminal RESETIN is a signal output from the signal output terminal OUTPUT of the shift register G_n+1 which is at a next stage of the shift register G_n. The fourth transistor M4 is turned on, so the voltage at the PU node which is connected with the fourth transistor M4 is pulled down to the level VGL of the third voltage source, and in turn the sixth transistor M6 is turned off, so at this time the PD node is only connected with the fifth transistor M5 which is connected to the second voltage source, thus a voltage at the PD node becomes a high level because the second voltage source outputs a high level signal VGH. Since both of the gates of the second transistor M2 and the seventh transistor M7 are connected with the PD node, the second transistor M2 and the seventh transistor M7 are all turned on when the voltage at the PD node becomes the high level. Turning on the second transistor M2 further ensures that the PU node is pulled down to the low level VGL, and the third transistor M3 is turned off after the voltage at the PU node drops to the low level of the third voltage source because the gate of the third transistor M3 is connected with the PU node. Since the seventh transistor M7 is turned on, the signal output terminal OUTPUT is connected to the third voltage source and the signal output terminal OUTPUT is reset to the low level.

In a fourth phase, the clock signal input terminal CLK inputs a high level signal. Since the PD node is at the high level and the voltage at the PU node, that is, the gate of the third transistor M3, is still at the low level, the third transistor M3 still remains the turning-off state as in the third phase, thus the high level signal input from the clock signal input terminal CLK would not be transferred to the signal output terminal OUTPUT. Because the seventh transistor M7 is still in the turning-on state, the signal output terminal OUTPUT is still connected to the third voltage source, so that the signal output terminal OUTPUT goes on to output the low level signal VGL as in the third phase, then a coupling noise generated at the signal output terminal OUTPUT caused by the high level signal from the clock signal input terminal CLK is eliminated, which may ensure a stabilization in the signal output from the signal output terminal OUTPUT.

In a fifth phase, the clock signal input terminal CLK inputs a low level signal. Since the PD node is at the high level and the voltage at the PU node, that is, the gate of the third transistor M3, is still at the low level, the third transistor M3 still remains the turning-off state as in the third phase, and since the seventh transistor M7 is still in the turning-on state, the signal output terminal OUTPUT is still connected to the third voltage source, so that the signal output terminal OUTPUT goes on to output the low level signal VGL as in the third phase.

Thereafter, the fourth phase and the fifth phase are repeated sequentially, and the first phase will not be re-started until the shift register according to the embodiments of the present disclosure receives a high level signal from the signal input terminal INPUT.

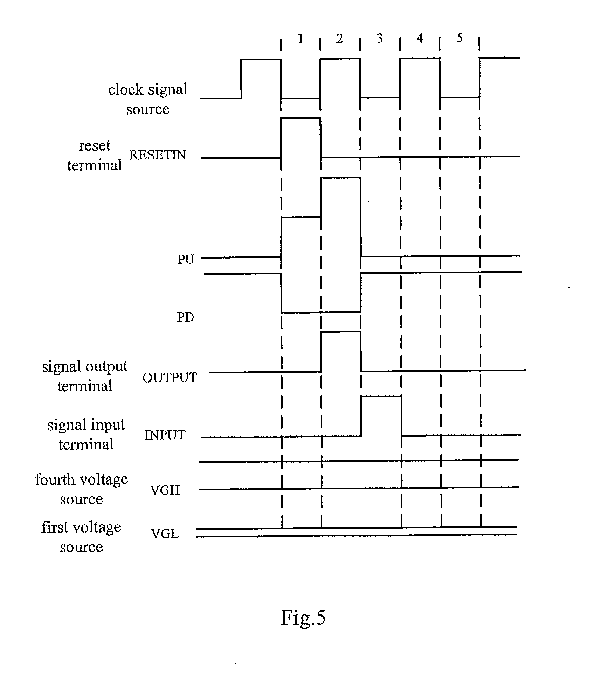

Fig.5 is an operation timing sequence diagram when the shift register scans backward according to the embodiments of the present disclosure. The timing sequence for backward scanning of the shift register illustrated in Fig.5 may be divided into five phases, and the first voltage source outputs a low level signal VGL while the fourth voltage source outputs a high level signal VGH during a process of the backward scanning. At this time, the reset terminal RESETIN illustrated in Fig.3 functions as a signal input terminal INPUT for the backward scanning, and the signal input terminal INPUT illustrated in Fig.3 functions as a reset terminal RESETIN for the backward scanning.

In a first phase, the reset terminal RESETIN of the shift register G_n inputs a high level signal, since the input signal at the reset terminal RESETIN of the shift register G_n is an output signal from the signal output terminal OUTPUT of the shift register G_n+1 which is at a next stage of the shift register G_n, it means that the high level signal at the signal output terminal OUTPUT of the shift register G_n+1 at the next stage of the shift register G_n is input to the reset terminal RESETIN of the shift register G_n. Then, the fourth transistor M4 is turned on, the fourth voltage source charges the capacitor C through the fourth transistor M4, so a voltage at the PU node is pulled up to the high level, and in turn the sixth transistor M6 is driven by the high voltage at the PU node to be turned on; by designing sizes of the fifth transistor M5 and the sixth transistor M6, a voltage at the pulling-down node PD node is at a low level, therefore the second transistor M2 and the seventh transistor M7 are turned off; the clock signal input terminal CLK input a low level signal, the third transistor M3 is turned on, thus the low level signal input from the clock signal input terminal CLK is transferred to the signal output terminal OUTPUT via the third transistor M3.

In a second phase, the reset terminal RESETIN of the shift register G_n inputs a low level signal, the fourth transistor M4 is turned off, but the voltage at the PU node is still at the high level because the capacitor C has stored the high level signal input from the fourth voltage source during the first phase, and at this time, the clock signal input terminal CLK inputs a high level signal, so the voltage at the PU node raises because of a bootstrapping effect of the capacitor C, that is to say, the voltage at one terminal of the capacitor C which is connected with the PU node raises continuously on a basis of the voltage obtained during the first phase, and the third transistor M3 remains the turning-on state, so that the high level signal input from the clock signal input terminal CLK is transferred to the signal output terminal OUTPUT via the third transistor M3. The pulling-down node PD goes on to remain the low level as in the first phase, therefore the second transistor M2 and the seventh transistor M7 go on to remain the turning-off state, which may prevent the high level signal output from the signal output terminal OUTPUT from being pulled down to the low level VGL.

In a third phase, the signal input terminal INPUT of the shift register G_n inputs a high level signal, the clock signal input terminal CLK inputs a low level signal, wherein the high level signal input from the signal input terminal INPUT is a signal output from the signal output terminal OUTPUT of the shift register G_n-1 which is at a previous stage of the shift register G_n. The first transistor M1 is turned on, so the voltage at the PU node which is connected with the first transistor M1 is pulled down to the low level VGL of the first voltage source, and in turn the sixth transistor M6 is turned off, so at this time the PD node is only connected with the fifth transistor M5 which is connected to the second voltage source, thus a voltage at the PD node becomes a high level because the second voltage source outputs the high level signal VGH. Since both of the gates of the second transistor M2 and the seventh transistor M7 are connected with the PD node, the second transistor M2 and the seventh transistor M7 are both turned on when the voltage at the PD node becomes the high level. Turning on the second transistor M2 further ensures that the PU node is pulled down to the low level VGL, and the third transistor M3 is turned off after the voltage at the PU node drops to the low level of the first voltage source because the gate of the third transistor M3 is connected with the PU node. Since the seventh transistor M7 is turned on, the signal output terminal OUTPUT is connected to the third voltage source and the signal output terminal OUTPUT is reset to the low level.

In a fourth phase, the clock signal input terminal CLK inputs a high level signal. Since the PD node is at the high level and the voltage at the PU node, that is, the gate of the third transistor M3, is still at the low level, the third transistor M3 still remains the turning-off state as in the third phase, thus the high level signal input from the clock signal input terminal CLK would not be transferred to the signal output terminal OUTPUT. Because the seventh transistor M7 is still in the turning-on state, the signal output terminal OUTPUT is still connected to the first voltage source, so that the signal output terminal OUTPUT goes on to output the low level signal VGL as in the third phase, then a coupling noise generated at the signal output terminal OUTPUT caused by the high level signal from the clock signal input terminal CLK is eliminated, which may ensure a stabilization in the signal output from the signal output terminal OUTPUT.

In a fifth phase, the clock signal input terminal CLK inputs a low level signal. Since the PD node is at the high level and the voltage at the PU node, that is, the gate of the third transistor M3, is still at the low level, the third transistor M3 still remains the turning-off state as in the third phase, and because the seventh transistor M7 is still in the turning-on state, the signal output terminal OUTPUT is still connected to the first voltage source, so that the signal output terminal OUTPUT goes on to output the low level signal VGL as in the third phase.

Thereafter, the fourth phase and the fifth phase are repeated sequentially, and the first stage will not be re-started until the shift register according to the embodiments of the present disclosure receives a high level signal from the reset terminal RESETIN.

The connection manners for the respective transistors are same when the shift register scans forward and backward, except that level signal output from the first voltage source and the fourth voltage source are different. In particular, the first voltage source outputs a high level signal and the fourth voltage source outputs a low level signal when the shift register scans forward; the first voltage source outputs a low level signal and the fourth voltage source outputs a high level signal when the shift register scans backward.

In the embodiments of the present disclosure, the shift register comprises the first voltage source, the third voltage source, the second voltage source and the fourth voltage source, wherein the level signals output from each of the voltage sources are different for the forward scanning and the backward scanning. In particular:

the first voltage source outputs a high level signal when the shift register scans forward, and outputs a low level signal when the shift register scans backward;

the third voltage source outputs a low level signal VGL both when the shift register scans forward and backward;

the second voltage source outputs a high level signal VGH both when the shift register scans forward and backward;

the fourth voltage source outputs a low level signal when the shift register scans forward, and outputs a high level signal when the shift register scans backward.

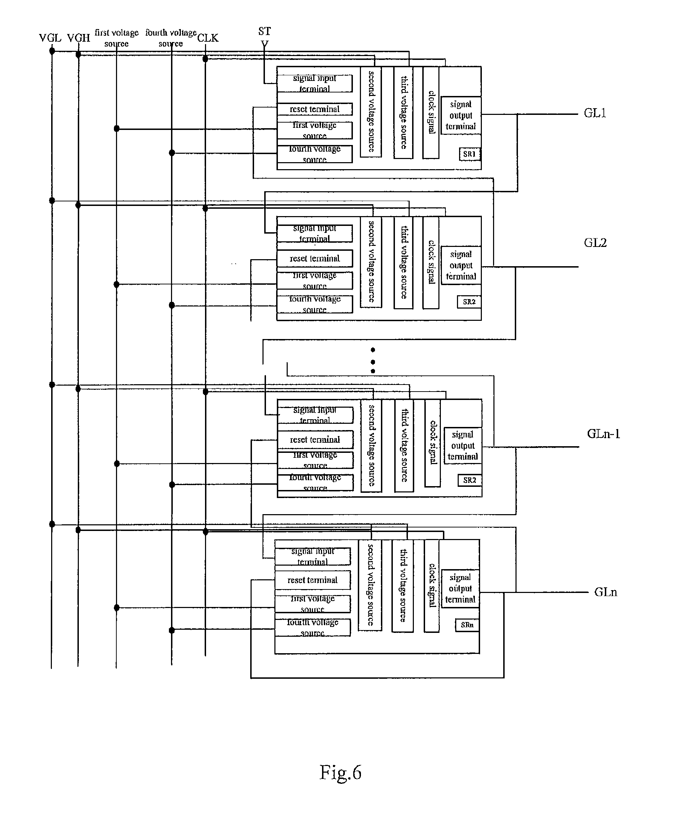

Referring to Fig.6, the embodiments of the present disclosure provide a gate driving circuit based on the above shift register (by taking a case in which all of the shift registers scan forward as an example, that is, the first voltage source outputs a high level signal and the fourth voltage source outputs a low level signal), the gate driving circuit comprises a shift register SR1, a shift register SR2, a shift register SR, ..., a shift register SRn; for any shift register of the shift register SR2, the shift register SR3, ..., the shift register SRn-1, signal from the signal output terminal of the shift register may be transferred to a reset terminal of the shift registers at its previous stage and a signal input terminal of the shift registers at its next stage. A signal input terminal of the shift register SR1 receives an initial start signal STV, and a reset terminal of the shift register SRn is connected with a signal output terminal of the shift register SRn.

Although it is illustrated that each of the shift register stages is connected to a clock signal CLK in Fig.6, those skilled in the art should understand that the clock signal CLK herein comprises both the clock signal CLK and the clock signal CLKB in fact.

In the gate driving circuit of the liquid crystal display according to any one embodiment of the present disclosure, signals at the clock signal input terminals of two adjacent shift register stages have opposite amplitudes, for example, the clock signal input terminal of the shift register SR2 inputs a high level signal, while the clock signal input terminals of the shift register SR1 and the shift register SR3 input a low level signal. In other words, the clock signal input terminal of the shift register SR(2k-1) inputs the clock signal CLK, and the clock signal input terminal of the shift register SR(2k) inputs the clock signal CLKB, wherein k is an integer being greater than or equal to 1 and smaller than or equal to n/2, and the phases of the clock signal CLK and the clock signal CLKB have a difference of 180°.

Other than a redundant shift register(s), each of the shift register stages converts an input clock signal into an ON signal or an OFF signal and outputs the same to a corresponding gate line from its signal output terminal. For example, the shift register SR1 converts the signal received at its clock signal input terminal into the ON signal or the OFF signal and outputs the same to a corresponding gate line GL1 from its signal output terminal, and the shift register SRn converts the signal received at its clock signal input terminal into the ON signal or the OFF signal and outputs the same to a corresponding gate line GLn from its signal output terminal.

The embodiments of the present disclosure further provide a liquid crystal display which comprises the gate driving circuit described above.

In conclusion, the embodiments of the present disclosure provide a shift register, a corresponding gate driving circuit and a liquid crystal display, wherein the shift register comprises a precharging module, a pulling-up module, a pulling-down driving module, a pulling-down module and a resetting module, each shift register may perform a bi-directional scanning, that is, it may scan not only forward but also backward, which may reduce a cost for producing the liquid crystal display including the shift registers, and at the same time may reduce a process complexity and increase a manufacturing efficiency.

The embodiment of the disclosure being thus described, it will be obvious that the same may be varied in many ways. Such variations are not to be regarded as a departure from the spirit and scope of the disclosure, and all such modifications as would be obvious to those skilled in the art are intended to be included within the scope of the following claims.

## Claims

1. A shift register comprising:
a precharging module, a pulling-up module, a pulling-down driving module, a pulling-down module and a resetting module;
wherein the precharging module is connected with a first voltage source and a signal input terminal and used for precharging a pulling-up node under the control of a voltage at the signal input terminal, the pulling-up node is a connection point between the pulling-up module and the precharging module;
the pulling-up module is connected with a clock signal source and a signal output terminal, and used for connecting the clock signal source to the signal output terminal under the control of a voltage at the pulling-up node;
the pulling-down driving module is connected with the pulling-up node, a third voltage source and a second voltage source, and used for connecting a pulling-down node to the third voltage source under the control of the voltage at the pulling-up node, the pulling-down node is a connection point between the pulling-down driving module and the pulling-down module;
the pulling-down module is connected with the pulling-up node, the pulling-down node, the third voltage source and the signal output terminal, and used for connecting the pulling-up node to the third voltage source and connecting the signal output terminal to the third voltage source under the control of a voltage at the pulling-down node;
the resetting module is connected with a fourth voltage source, a reset terminal and the pulling-up node, and used for connecting the pulling-up node to the fourth voltage source under the control of a signal at the reset terminal.

2. The shift register of claim 1, wherein,
the precharging module comprises a first transistor, wherein a gate of the first transistor is connected with the signal input terminal, a source of the first transistor is connected with the first voltage source, and a drain of the first transistor is connected with the pulling-up node;
the pulling-up module comprises: a third transistor, wherein a gate of the third transistor is connected with the pulling-up node, a source of the third transistor is connected with the clock signal source, and a drain of the third transistor is connected with the signal output teminal; and a capacitor connected between the pulling-up node and the signal output terminal;
the pulling-down driving module comprises: a fifth transistor, wherein a gate of the fifth transistor is connected with a source of the fifth transistor, the source of the fifth transistor is connected with the second voltage source at the same time, and a drain of the fifth transistor is connected with the pulling-down node; and a sixth transistor, wherein a gate of the sixth transistor is connected with the pulling-up node, a drain of the sixth transistor is connected with the third voltage source, and a source of the sixth transistor is connected with the pulling-down node;
the pulling-down module comprises: a second transistor, wherein a source of the second transistor is connected with the pulling-up node, a drain of the second transistor is connected with the third voltage source, and a gate of the second transistor is connected with the pulling-down node; and a seventh transistor, wherein a gate of the seventh transistor is connected with the pulling-down node, a drain of the seventh transistor is connected with the third voltage source, and a source of the seventh transistor is connected with the signal output terminal;
the resetting module comprises a fourth transistor, wherein a gate of the fourth transistor is connected with the reset terminal, a drain of the fourth transistor is connected with the fourth voltage source, and a source of the fourth transistor is connected with the pulling-up node.

3. The shift register of claim 2, wherein the transistors are N-type field effect transistors.

4. The shift register of claim 2, wherein a size ratio between the fifth transistor and the sixth transistor is a preset value.

5. The shift register of claim 4, wherein,
the first voltage source outputs a high level signal and the fourth voltage source outputs a low level signal when the shift register scans forward;
the first voltage source outputs a low level signal and the fourth voltage source outputs a high level signal when the shift register scans backward,
wherein the signal input terminal for the forward scanning functions as the reset terminal for the backward scanning, and the reset terminal for the forward scanning functions as the signal input terminal for the backward scanning.

6. A gate driving circuit comprising: n shift registers of any of claims 1-5, wherein,
the third voltage source inputs a low level signal while the second voltage source inputs a high level signal in each of the shift registers, wherein, when a forward scanning is performed, the first voltage source outputs a high level signal while the fourth voltage source outputs a low level signal in each of the shift registers; when a backward scanning is performed, the first voltage source outputs a low level signal while the fourth voltage source outputs a high level signal in each of the shift registers;
the signal output terminal of each of the shift registers is connected to a corresponding gate line;
the signal input terminal of a first shift register of the shift registers is connected to a start signal input terminal;
the signal input terminal of a m^{th} shift register of the shift registers is connected to the signal output terminal of a (m-1)^{th} shift register of the shift registers, the signal reset terminal of the m^{th} shift register is connected to the signal output terminal of a (m+1)^{th} shift register of the shift registers, wherein 1<m<n-1.

7. A liquid crystal display, comprising the gate driving circuit of claim 6.
